# EUROPEAN PATENT APPLICATION

(11) **EP 4 766 040 A1**
(43) Date of publication of application: **24.06.2026**
(21) Application number: 25204197.5
(22) Date of filing: 24.09.2025
(51) Int. Cl.: H05K 5/02, H02M 7/00, H05K 7/14, H05K 7/20, H01M 50/251, H01M 50/502, H01M 50/244

(54) **INVERTER AND ENERGY STORAGE SYSTEM INCLUDING THE SAME**

(30) Priority: 18.12.2024 KR 20240190088
(71) Applicant: Hanwha Solutions Corporation, Jung-gu Seoul 04541 (KR)
(72) Inventor: CHOI, You Chang, 04541 Seoul (KR); PARK, Je Hyun, 04541 Seoul (KR)
(74) Representative: Mooser, Sebastian Thomas

(57) **Abstract**

Provided is an inverter including a main case, a heat dissipation case that covers one side of the main case and has a plurality of heat dissipation fins, a circuit board unit arranged in an internal space defined by an assembly of the main case and the heat dissipation case, the circuit board unit having one or more circuit boards configured to mutually convert between direct current power and alternating current power, and a fixing member that connects the main case to an external storage device.

## Description

### BACKGROUND

### 1. Field

The present disclosure relates to an inverter and an energy storage system including the same.

### 2. Description of the Related Art

In general, an inverter is a device that converts direct current (DC) electricity generated by an electrical energy generation device, such as a solar module, into alternating current (AC) electricity, and stores electrical energy in a battery serving as a power storage device, and may also supply AC electricity to home appliances that consume AC electricity, and a power grid, and maintain power quality by adjusting an output voltage and frequency.

An inverter may be used as a standalone unit connected to a solar panel, a power grid, and the like, but may also be integrated with other external devices, such as an energy storage system (ESS), to serve as an all-in-one solution. This configuration may improve the efficiency of power conversion and storage.

### SUMMARY

The present disclosure provides an inverter with improved installation and replacement convenience and enhanced sealing performance, and an energy storage system including the inverter.

Additional aspects will be set forth in part in the description which follows and, in part, will be apparent from the description, or may be learned by practice of the presented embodiments of the disclosure.

An embodiment of the present disclosure provides an inverter including: a main case; a heat dissipation case that covers one side of the main case and has a plurality of heat dissipation fins; a circuit board unit arranged in an internal space defined by an assembly of the main case and the heat dissipation case, the circuit board unit having one or more circuit boards configured to mutually convert between direct current power and alternating current power; and a fixing member that connects the main case to an external storage device.

In an embodiment, the main case may include a guide protrusion formed to protrude from a surface thereof.

In an embodiment, a surface of the main case may have a coupling groove that is recessed inward to have a preset depth, and to which the storage device is connectable.

In an embodiment, the coupling groove may include: a first surface that faces the storage device; and a second surface connected to the first surface and arranged to be inclined outward.

In an embodiment, the inverter may further include a gasket arranged in a circumferential direction on an inner surface of the coupling groove and contactable to a connection protrusion that is formed to protrude from a surface of the storage device.

In an embodiment, the gasket may include an elastically deformable material.

In an embodiment, the fixing member may include a guide hole that is couplable to the main case.

In an embodiment, the guide hole may include a plurality of guide holes that are couplable to the main case and the storage device, respectively.

In an embodiment, the inverter may further include a support member arranged between the heat dissipation case and the storage device to support the heat dissipation case.

In addition, another embodiment of the present disclosure provides an energy storage system including: an inverter; and a storage device, wherein the inverter includes: a main case; a heat dissipation case that covers one side of the main case and has a plurality of heat dissipation fins; a circuit board unit arranged in an internal space defined by an assembly of the main case and the heat dissipation case, the circuit board unit having one or more circuit boards configured to mutually convert between direct current power and alternating current power; and a fixing member that connects the main case to an external storage device, and the inverter and the storage device are electrically connected to each other.

In an embodiment, the main case may include a guide protrusion formed to protrude from a surface thereof.

In an embodiment, a surface of the main case may have a coupling groove that is recessed inward to have a preset depth, and to which the storage device is connectable.

In an embodiment, the energy storage system may further include a gasket arranged in a circumferential direction on an inner surface of the coupling groove and contactable to a connection protrusion that is formed to protrude from a surface of the storage device.

In an embodiment, the fixing member may include a guide hole that is couplable to the main case.

In an embodiment, the energy storage system may further include a support member arranged between the heat dissipation case and the storage device to support the heat dissipation case.

Other aspects, features, advantages other than those described above will become apparent from the following drawings, claims, and detailed description of the present disclosure.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a block diagram schematically illustrating an energy storage and distribution system according to an embodiment of the present disclosure;
FIG. 2 is a block diagram schematically illustrating an energy storage system and a controller, according to an embodiment of the present disclosure;
FIG. 3 is a diagram illustrating coupling between an inverter and a storage device, according to an embodiment of the present disclosure;
FIG. 4 is an exploded perspective view of the inverter of FIG. 3;
FIG. 5 is a diagram illustrating an inverter with its door open, according to an embodiment of the present disclosure;
FIG. 6 is a bottom view of an inverter according to an embodiment of the present disclosure;
FIG. 7 is a rear view of an inverter according to an embodiment of the present disclosure;
FIG. 8 is an enlarged view of portion A of FIG. 5;
FIG. 9 is a cross-sectional view taken along line V-V' of FIG. 5; and
FIG. 10 is an enlarged view of portion B of FIG. 7.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects.

As the present disclosure allows for various changes and numerous embodiments, particular embodiments will be illustrated in the drawings and described in detail. Advantages and features of the present disclosure and a method of achieving the same should become clear with embodiments described below in detail with reference to the drawings. However, the present disclosure is not limited to the embodiments disclosed below, but may be implemented in various forms.

Hereinafter, embodiments of the present disclosure will be described in detail with reference to the accompanying drawings, and the same or corresponding components will be denoted by the same reference numerals when described with reference to the accompanying drawings, and thus, their descriptions that are already provided will be omitted.

In the following embodiments, terms such as "first," "second," etc., are used only to distinguish one component from another, and such components must not be limited by these terms.

In the following embodiments, the singular expression also includes the plural meaning as long as it is not inconsistent with the context.

In the following embodiments, the terms "comprise," "include," "have," and the like used herein specify the presence of stated features or components, but do not preclude the presence or addition of one or more other features or components.

In the following embodiments, when an element such as a layer, region, or component is referred to as being "on," "in front of," "behind," or "under" another element, it may encompass cases where the elements are in direct contact, as well as cases where intervening elements may be present.

For convenience of descriptions, the magnitude of components in the drawings may be exaggerated or reduced. For example, the size and thickness of each element illustrated in the drawings are provided arbitrarily for convenience of descriptions, and thus, the present disclosure is not necessarily limited to those illustrated in the drawings.

In addition, it should be understood that some elements may be omitted, only a part of an element may be illustrated, or an element may be schematically represented in the drawings for the purpose of simplification, or when deemed sufficient or necessary for the description.

In the following embodiments, when an element is referred to as being "connected" to another element, this may include both cases where they are directly connected and cases where they are indirectly connected with other elements therebetween.

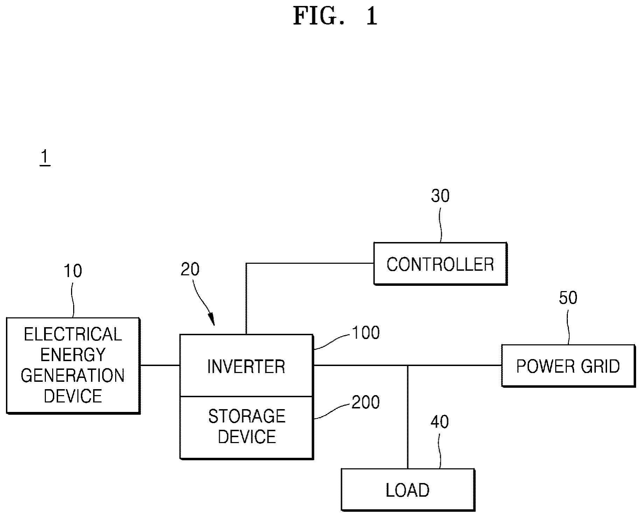

FIG. 1 is a block diagram schematically illustrating an energy storage and distribution system according to an embodiment of the present disclosure.

Referring to FIG. 1, an energy storage and distribution system 1 may convert direct current (DC) electricity generated from an electrical energy generation device 10 such as a solar module, into alternating current (AC) electricity, and supply the AC electricity to a load 40, a power grid 50, and the like, or may store power generated from the electrical energy generation device 10 in a storage device 200, and then convert and supply the stored power as needed.

The electrical energy generation device 10 refers to a device that generates electrical energy by converting various forms of energy, and may generate electrical energy in various ways depending on the type of energy source.

For example, the electrical energy generation device 10 may be a solar module that converts sunlight into electrical energy by using a solar panel. However, the present disclosure is not limited thereto, and the electrical energy generation device 10 may be provided as various devices, such as a wind power generation device or a hydroelectric power generation device.

An energy storage system 20 stores electricity generated from the electrical energy generation device 10, such as a solar module, and converts the stored DC electricity into AC electricity to supply the AC electricity to an external destination, and may include an inverter 100 and the storage device 200.

The inverter 100 may be connected to or integrated with the storage device 200. Accordingly, DC electricity generated from the electrical energy generation device 10 may be stored in the storage device 200 and then converted into AC electricity by the inverter 100 to be supplied to the load 40, the power grid 50, and the like, as needed.

However, the present disclosure is not limited thereto, and within the technical scope of being able to mutually convert between DC electricity and AC electricity from an external source, the inverter 100 may be connected to or integrated with various components of the energy storage and distribution system, such as a converter, a battery management system (BMS), or a power management system.

A controller 30 is electrically connected to the energy storage system 20, and may receive operation data from the energy storage system 20 to monitor its operational status and control its operating conditions.

In some embodiments, the controller 30 may check the operational status of the inverter 100 in real time. In some embodiments, the controller 30 may receive, from the inverter 100, information about various parameters of the electrical energy generation device 10, such as the total amount of power generation or the AC voltage. In some embodiments, when a defect or failure occurs during the operation of the inverter 100, the controller 30 may generate an alarm to notify a user.

The load 40 is a general term referring to any device that consumes electricity, and examples of the load 40 may include household electrical appliances, heating and cooling systems, lighting and equipment in commercial facilities, and machinery in industrial sites. In general, because the load 40 uses AC electricity, DC electricity introduced to charge the storage device 200 is converted into AC electricity by the inverter 100 and then supplied to the load 40.

The power grid 50 may be defined as a power network that transmits and distributes AC electricity, which has been converted by the inverter 100, to supply the AC electricity to consumers. The power grid 50 may be connected to an electrical distribution network of a house or building to distribute electrical energy supplied from the electrical energy generation device 10 or the energy storage system 20.

In other words, the energy storage and distribution system 1 according to an embodiment of the present disclosure may be a power network where electrical energy generated from the electrical energy generation device 10 enters the energy storage system 20 to be stored in the storage device 200, or the stored electrical energy is converted and supplied to the load 40 and the power grid 50 to be ultimately delivered to consumers.

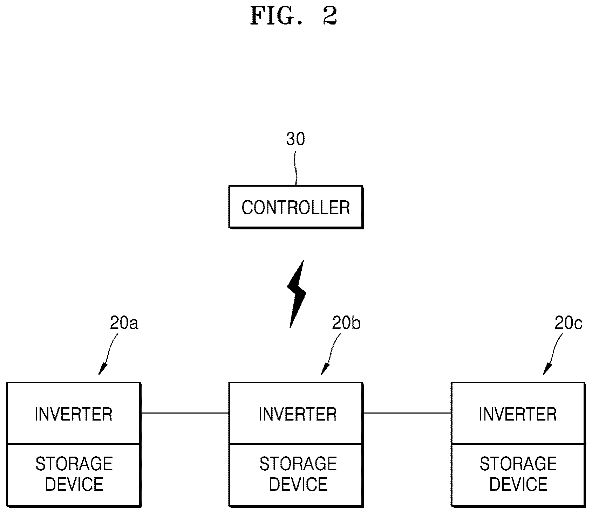

FIG. 2 is a block diagram schematically illustrating the energy storage system 20 and the controller 30, according to an embodiment of the present disclosure.

Referring to FIG. 2, a plurality of energy storage systems 20 may be provided and connected to each other. The number of energy storage systems 20 is not limited to a specific number and may be variously configured depending on the installation location of the energy storage systems 20, or the like. However, for convenience of descriptions, the following description will focus on an embodiment in which three energy storage systems 20a, 20b, and 20c are connected to the controller 30.

In an embodiment, the energy storage systems may include a first energy storage system 20a, a second energy storage system 20b, and a third energy storage system 20c, which may be electrically connected to each other. For example, the first energy storage system 20a, the second energy storage system 20b, and the third energy storage system 20c may be connected to each other by cables to transmit electrical signals or to allow current to flow between them.

The controller 30 according to an embodiment of the present disclosure may be connected to the first energy storage system 20a, the second energy storage system 20b, and the third energy storage system 20c via wired or wireless communication.

In a case in which the controller 30 is connected via a wired connection to the first energy storage system 20a, the second energy storage system 20b, and the third energy storage system 20c, the controller 30 may be connected to a storage device of any one of the first energy storage system 20a, the second energy storage system 20b, and the third energy storage system 20c, and may receive operation data from the other storage devices.

In another embodiment, the controller 30 may be connected to each of the first energy storage system 20a, the second energy storage system 20b, and the third energy storage system 20c to receive their respective operation data.

In some embodiments, the controller 30 may be wirelessly connected to the energy storage system 20 to receive operation data via wireless communication.

As the controller 30 monitors information about the energy storage system 20 and the inverter 100 in real time and adjusts operating conditions, it is possible to immediately respond to a problem occurring during the operation of the inverter 100, and a power consumption or the like is output in real time such that processes of generating, storing, and distributing electrical energy are performed more efficiently.

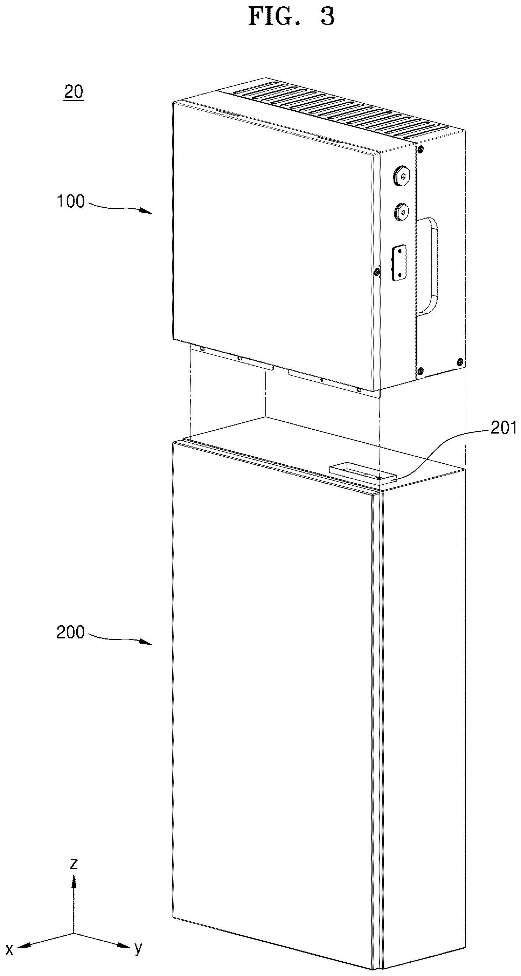

FIG. 3 is a diagram illustrating coupling between an inverter and a storage device, according to an embodiment of the present disclosure.

Referring to FIG. 3, the energy storage system 20 according to an embodiment of the present disclosure may include the inverter 100 and the storage device 200.

The inverter 100 and the storage device 200 may be electrically connected to each other via a DC connector or AC connector (not shown), and accordingly, the inverter 100 may receive DC electricity or convert the received DC electricity into AC electricity to transmit the AC electricity to an external destination.

In other words, the inverter 100 may be electrically connected to the storage device 200 to supply power to the storage device 200, or receive power from the storage device 200 to output the power to an external destination.

The inverter 100 may be coupled to the storage device 200 in a vertical direction. In the present specification, the term "vertical direction" may refer to a z-axis direction, an up-down direction in FIG. 3, and a lengthwise direction of the storage device 200.

In some embodiments, the inverter 100 may be connected to a connection protrusion 201 of the storage device 200. The connection protrusion 201 may have the shape of a partition wall that surrounds a preset area of the storage device 200 that faces the inverter 100.

Here, a connection cable, a wire, a connector, or the like, which electrically connects the inverter 100 to the storage device 200, may pass through a surface of the storage device 200 that is enclosed by the connection protrusion 201 to be connected to a connection terminal inside the inverter 100. The coupling between the connection protrusion 201 and the inverter 100 will be described in detail below.

The storage device 200 may be a power storage device for storing electrical energy supplied from an external electrical energy generation device 10.

Thus, although the present specification describes an example in which the storage device 200 is a power storage device, the present disclosure is not limited thereto, and various modifications may be made to other external devices within the technical scope where the storage device 200 may be electrically connected to the inverter 100 capable of mutually converting between DC power and AC power.

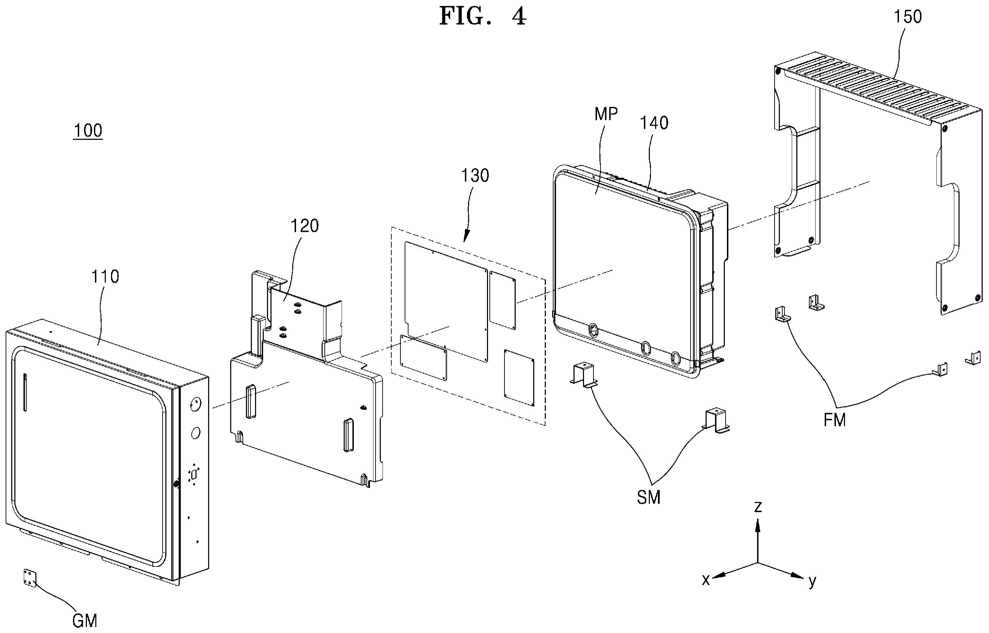

FIG. 4 is an exploded perspective view of the inverter of FIG. 3.

Referring to FIG. 4, the inverter 100 is capable of mutually converting between DC electricity and AC electricity supplied from an external source, and may include a main case 110, a safety cover 120, a circuit board unit 130, a heat dissipation case 140, and a hood cover 150.

The main case 110, the safety cover 120, the circuit board unit 130, and the heat dissipation case 140 may be coupled to each other in a first direction. In the present specification, the term "first direction" may refer to an x-axis direction, and the term "second direction" may refer to a y-axis direction.

The main case 110 may be connected to the storage device 200 through a fixing member GM. The heat dissipation case 140, which covers one side of the main case 110 and has a plurality of heat dissipation fins 143, defines an internal space in which the circuit board unit 130 may be arranged.

In the present specification, the term "internal space" may refer to a space that is defined by the assembly of the main case 110 and the heat dissipation case 140. In other words, the internal space may refer to a space enclosed by the main case 110 and the heat dissipation case 140.

In some embodiments, the safety cover 120 that covers the circuit board unit 130 may be arranged in the internal space. The safety cover 120 may be arranged on one side of the circuit board unit 130 and may protect a plurality of circuit boards from an external environment, thereby preventing the circuit boards from being exposed to the external environment during the installation of the inverter 100, and reducing the likelihood of failure and malfunction of the inverter 100.

In some embodiments, the safety cover 120 may physically separate components through which current flows, from a worker, thereby preventing electric shock accidents and enhancing the safety of the working environment.

The circuit board unit 130 may be arranged in the internal space and may have at least one circuit board capable of mutually converting between DC power and AC power.

In an embodiment, the circuit board unit 130 may include a first board 131, a second board 132, a third board 133, and a fourth board 134. Here, the circuit boards may be referred to as "circuit boards" or "a plurality of circuit boards".

Each circuit board may be provided as a filter board, a main board, a battery management and protection system (BMPS) board, a switching-mode power supply (SMPS) board, or the like, and may include power semiconductors such as metal-oxide-semiconductor field-effect transistors (MOSFETs) or insulated-gate bipolar transistors (IGBTs), control circuits, sensors, printed circuit boards, and the like. Here, the respective circuit boards may be stacked and arranged within the internal space, or may be arranged to be spaced apart from each other on the same plane.

A main plate MP may be arranged between the safety cover 120 and the heat dissipation case 140. The main plate MP, which supports at least one circuit board of the circuit board unit 130, may partition the internal space.

The plurality of circuit boards may be arranged on opposite sides of the main plate MP. In other words, the circuit boards may be arranged in the multiple spaces that are partitioned by the main plate MP. Thus, although not shown in the drawings, the circuit boards may be arranged not only in the space between the safety cover 120 and the main plate MP but also in the space between the main plate MP and the heat dissipation case 140.

Accordingly, the plurality of circuit boards included in the circuit board unit 130 may be stacked in the first direction within the internal space of the inverter 100.

The heat dissipation case 140 may be formed to protrude in the first direction. As the heat dissipation case 140 is formed to protrude outward, an inner side of the protruding area is concavely formed, thereby providing an internal space.

At least one circuit board may be accommodated in the space enclosed by the heat dissipation case 140 and the main plate MP. Accordingly, the plurality of circuit boards included in the circuit board unit 130 may be completely enclosed by the main case 110, the safety cover 120, and the heat dissipation case 140.

The heat dissipation case 140 may have a plurality of heat dissipation fins 143, and may efficiently dissipate heat generated from the circuit board unit 130 to the outside. Accordingly, the heat dissipation case 140 may prevent excessive heat from accumulating inside the inverter 100 to cause performance degradation of the circuit boards or defects during operation.

The hood cover 150 surrounds the heat dissipation case 140 and connects to the main case 110, and may be arranged to cover the side and upper surfaces of the heat dissipation case 140, thereby protecting the heat dissipation case 140 from the outside.

In some embodiments, the hood cover 150 may physically block a user or worker from contacting the surface of the heat dissipation case 140, which reaches a high temperature due to heat generated from the internal circuit boards, thereby protecting the user and worker.

A lower portion of the hood cover 150 may be connected to the upper surface of the storage device 200. In some embodiments, areas corresponding to the corners of the lower portion of the hood cover 150 may be fastened to the storage device 200 by fastening members FM, respectively. Accordingly, the inverter 100 may be securely fixed on the storage device 200.

The fastening member FM is fastened to the hood cover 150 and may connect the hood cover 150 to the storage device 200.

A plurality of fastening members FM may be provided. Some of the plurality of fastening members FM may be fixed by welding to a rear surface part of a main body 111, to fix the four corners of the hood cover 150 to the main case 110, and more specifically, to the main body 111.

In some embodiments, others of the plurality of fastening members FM may be welded onto the storage device 200, to fix opposite lower end portions (the lower side in FIG. 4) of the hood cover 150 to the storage device 200.

Because the main case 110 is connected to the hood cover 150 by the fastening members FM, and the hood cover 150 is connected to the storage device 200, the main case 110 may be indirectly fixed to the storage device 200.

The inverter 100 may further include the fixing member GM and support members SM.

The fixing member GM, which connects the main case 110 to the storage device 200, may be formed to extend in a vertical direction, such that one side thereof may be connected to the main case 110, and the other side thereof may be connected to the storage device 200.

Accordingly, the fixing member GM may maintain the fixation between the main body 111 and a front portion (the left side in FIG. 4) of the storage device 200, even when a door 112 is opened or detached.

In some embodiments, the fixing member GM may provide guidance when the inverter 100 and the storage device 200 are connected to each other, such that each component may be aligned with a common center in a vertical direction. This will be described in detail below.

The support member SM is arranged between the heat dissipation case 140 and the storage device 200, and one surface of the support member SM may contact the storage device 200, and the opposite surface may contact the heat dissipation case 140.

Accordingly, the support members SM may stably support a lower portion of the heat dissipation case 140 that protrudes in the first direction, and may space the heat dissipation case 140 apart from the storage device 200 by a preset interval.

A plurality of support members SM may be provided, and the plurality of support members SM may be respectively arranged on opposite sides of the heat dissipation case 140 to distribute the weight of the heat dissipation case 140 and thereby provide more stable support.

The upper surface (the upper side in FIG. 4) of the support member SM may undergo a masking treatment to serve as a ground connection between the heat dissipation case 140 and the storage device 200. Accordingly, the support members SM may physically support the inverter 100 and simultaneously improve the electrical stability of the entire energy storage system 20.

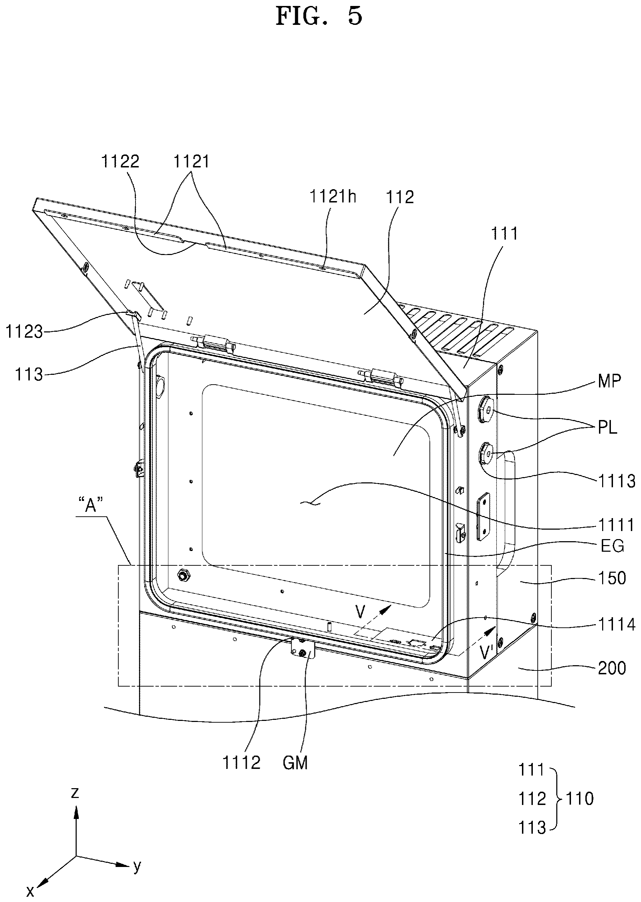

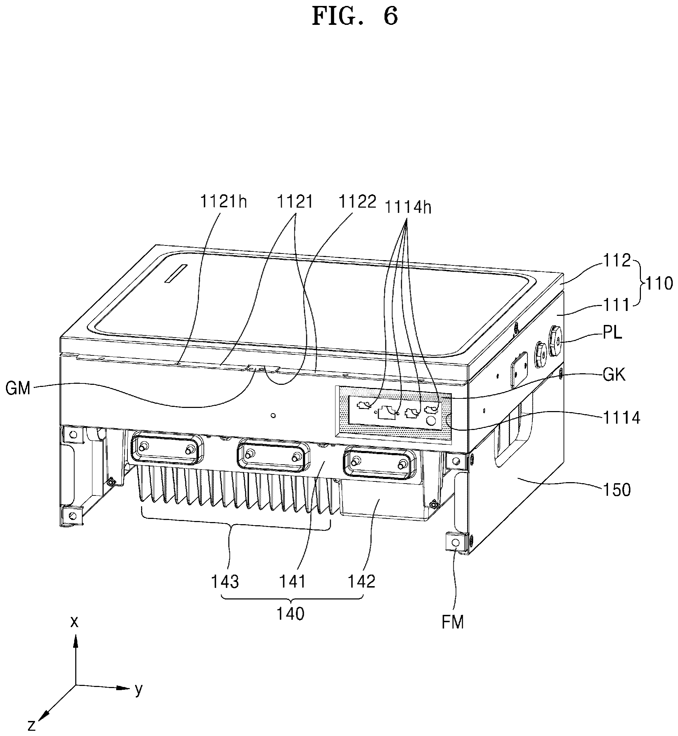

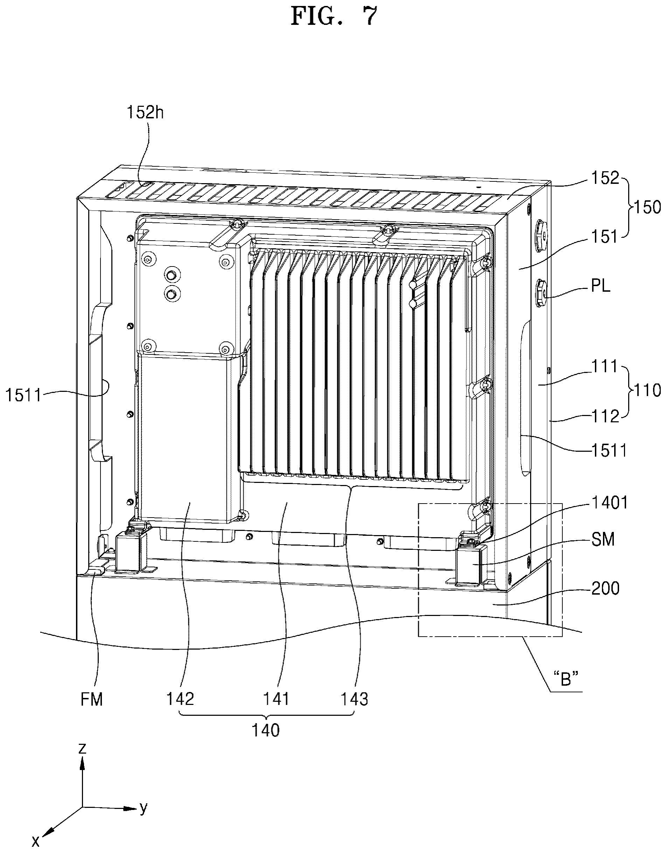

FIG. 5 is a diagram illustrating an inverter with its door open, according to an embodiment of the present disclosure, FIG. 6 is a bottom view of an inverter according to an embodiment of the present disclosure, and FIG. 7 is a rear view of an inverter according to an embodiment of the present disclosure.

Referring to FIGS. 5 to 7, the main case 110 may include the main body 111, the door 112, and safety rods 113.

The main case 110 has an internal space defined by its assembly with the heat dissipation case 140, and is installed in the storage device 200, and the circuit board unit 130 and the safety cover 120 may be arranged in the internal space of the main case 110. However, for convenience of descriptions, the configurations of the circuit board unit 130 and the safety cover 120 are omitted in FIG. 5.

The main body 111 may have an internal space therein and an opening 1111 on one of its surfaces. Here, the opening 1111 may be covered by the door 112.

The door 112 is rotatably connected to the main body 111 and is capable of covering the opening 1111, and the area of the door 112 may correspond to the surface of the main body 111 on which the opening 1111 is formed.

Accordingly, a worker, as needed, may rotate the door 112 up and down to open and close the opening 1111, or attach or detach the door 112 to or from the main body 111, to perform tasks necessary for installing and replacing the inverter 100.

In the present specification, the door 112 is considered "open" (as illustrated in FIG. 5) when it does not cover the opening 1111, is supported by the safety rods 113, and is positioned at a preset angle with respect to the main body 111, and the door 112 is considered "closed" (as illustrated in FIG. 6) when it covers the opening 1111.

The safety rods 113, which are arranged between the main body 111 and the door 112, may support the door 112 to allow the door 112 to remain open.

One side of the safety rod 113 may be rotatably connected to the main body 111. In some embodiments, a slot-shaped rod hole (not shown) may be formed on one side of the safety rod 113. Here, the safety rod 113 may be constrained by a separate pin to a fixing bracket (not shown) that is arranged on a surface of the main body 111.

The rod hole extends in the lengthwise direction of the safety rod 113, and the safety rod 113 may perform not only rotational movement but also sliding movement in a vertical direction with respect to the main case 110.

Thus, when the safety rod 113 is hung on a rod support part 1123 and the door 112 forms a preset angle with respect to the main case 110, the safety rod 113 may slide down in the direction of gravity to be fixed in place.

Accordingly, when the door 112 moves partially due to an external force, such as a worker hitting it with their head or wind lifting it, the risk of the door 112 falling and injuring the worker may be physically prevented, and the safety of the working environment may be ensured.

Another side of the safety rod 113, which is not connected to the main body 111, may move freely to support the door 112 as the door 112 opens or closes, or may be located on a surface of the main body 111.

A shielding member EG may be arranged along the circumference of the opening 1111 of the main body 111. The shielding member EG may block electromagnetic waves that are generated by current flowing through the circuit board unit 130 arranged in the internal space of the main body 111, thereby preventing the electromagnetic waves from being emitted to the outside.

The shielding member EG may include various materials. For example, the shielding member EG may include aluminum, steel, polycarbonate, acrylonitrile butadiene styrene (ABS), silicone, rubber, or the like, and may be arranged along the circumference of the opening 1111, and various modifications to the material are possible within the technical scope where the material is capable of blocking electromagnetic waves emitted from the circuit board unit 130.

A guide protrusion 1112 may be formed to protrude from a surface of the main case 110. In some embodiments, the guide protrusion 1112 may be arranged on the lower side (the lower side in FIG. 5) of the main case 110 that is adjacent to the storage device 200.

The guide protrusion 1112, which protrudes in the first direction, may be arranged on the surface of the main body 111 on which the opening 1111 is formed. The guide protrusion 1112 may be connected to the fixing member GM to align the inverter 100 and the storage device 200 in a line.

In some embodiments, a separate protrusion may be formed on a surface of the storage device 200 to be arranged on the same plane as the guide protrusion 1112, and the fixing member GM may be simultaneously fit-coupled to the guide protrusion 1112 and the protrusion of the storage device 200 to linearly align the two devices.

A cable hole 1113, through which a cable for electrically connecting the inverter 100 to an external device may pass, may be formed on a surface of the main body 111. Here, the cable passing through the cable hole 1113 may be any of various types of cables, such as a power cable or a communication cable.

A plurality of cable holes 1113 may be arranged in a vertical direction on a surface of the main body 111. Accordingly, a plurality of cables connected to the inverter 100 may simultaneously pass through the main body 111 to connect to the internal circuit board unit 130 or to supply power.

In some embodiments, the cable holes 1113 may be arranged on opposite sides of the main body 111, respectively. Accordingly, a cable may selectively enter the left or right side of the inverter 100 to be easily connected to a destination.

A plug PL is coupled to the cable hole 1113 to seal the cable hole 1113 from the outside, and may be formed to have an outer diameter greater than an inner diameter of the cable hole 1113.

By using the plug PL, a gap between the cable and the cable hole 1113 may be completely filled, and external contaminants, moisture, and the like may be prevented from entering the interior space.

When a cable connection is necessary, the plug PL may be removed. A separate connector may be inserted into the cable hole 1113 from which the plug PL has been removed. For example, the connector may be a conduit connector.

The connector, with a cable mounted therein, may be inserted into the cable hole 1113 to seal the cable hole 1113. Accordingly, dust, moisture, and other external contaminants may be prevented from entering the internal space. In some embodiments, a cable that is mounted on the connector and has passed through the cable hole 1113 may be stably fixed in position and connected to the circuit board.

Referring to FIGS. 5 and 6, a surface of the main case 110 may have a coupling groove 1114 that is recessed inward to have a preset depth, and to which the storage device 200 may be connected.

In some embodiments, the coupling groove 1114 may be formed on a surface of the main case 110 that faces the storage device 200. Coupling holes 1114h, to which a plurality of connectors, wires, cables, or the like that may electrically connect the inverter 100 to the storage device 200 may be coupled, may be formed in the coupling groove 1114.

A plurality of cables extending from the storage device 200 may pass through the coupling holes 1114h and enter the inverter 100 to be directly coupled to circuit boards.

In some embodiments, a connector that is connected to a cable inside the inverter 100 may be coupled to the coupling hole 1114h. Here, a connector of a cable extending from the storage device 200 may be physically connected to a connector of the inverter 100, which is coupled to the coupling hole 1114h, to electrically connect the two devices to each other.

That is, the coupling groove 1114 may be a space where cables respectively extending from the inverter 100 and the storage device 200 are electrically or physically connected to each other.

The connection protrusion 201 of the storage device 200 may be positioned on a recessed inner side of the coupling groove 1114. The connection protrusion 201 protrudes toward the inverter 100 from a surface of the storage device 200, and may be formed at a position corresponding to the position of the coupling groove 1114.

Accordingly, when the inverter 100 is seated on the upper surface of the storage device 200, the connection protrusion 201 may be inserted into the coupling groove 1114 that has a preset depth.

Referring again to FIG. 3, the connection protrusion 201 may have the shape of a partition wall having a preset height and formed so as to correspond to the inner circumferential surface of the coupling groove 1114.

Referring to FIG. 6, a gasket GK is arranged along the inner circumferential surface of the coupling groove 1114 and may seal a gap between surfaces of the inverter 100 and the storage device 200 to block contaminants, moisture, or the like from an external environment from being introduced into the device.

The outer circumference of the gasket GK may be smaller than the inner circumference of the coupling groove 1114, and a hollow portion through which a cable, a wire, a connector, or the like may pass may be formed on the inner side of the gasket GK.

The gasket GK may include a material having an elastic restoring force. In other words, the gasket GK may include a compressible material and may be in close contact with the inner side of the coupling groove 1114. Furthermore, when installing the inverter 100 on the storage device 200, the gasket GK may be compressed by the connection protrusion 201 to fill a gap that may occur in the coupling groove 1114 during assembly.

Accordingly, the inside of the coupling groove 1114 may be completely blocked from the outside, and the introduction of external foreign substances into the inverter 100 may be prevented, such that the sealing performance of the inverter 100 is improved.

Referring to FIGS. 5 and 6, the door 112, which is rotatably connected to the main body 111 and is capable of covering the opening 1111, may prevent the circuit board unit 130 inside the main body 111 from being exposed to the outside.

In some embodiments, the door 112 may be hinge-connected to the main body 111 to be rotatable within a preset radius range. Accordingly, when installation of the inverter 100 is required, an operator may rotate and open the door 112 to expose internal terminals and the like, and after the installation is complete, may rotate the door 112 again to close the door 112 such that the interior is not exposed.

However, the present disclosure is not limited thereto, and during the installation of the inverter 100, a worker may remove the door 112 to perform a necessary task, and reattach the door 112 after the task is completed.

The door 112 may have an area corresponding to a surface of the main body 111 on which the opening 1111 is formed, and may completely cover the opening 1111 to prevent external contaminants from being introduced into the main body 111 through the opening 1111.

The door 112 may include extension tabs 1121 that are connected to the storage device 200. The extension tab 1121 is an area that extends toward the storage device 200 in a state in which the door 112 is closed, and may contact a surface of the storage device 200. In some embodiments, the extension tab 1121 may be arranged in the second direction at an end portion of the door 112.

The extension tab 1121 may be an area that is fastened to the storage device 200 and may have fixing holes 1121h arranged to be spaced apart from each other by a preset interval. The fixing holes 1121h may be arranged to be spaced apart from each other in the second direction on the extension tab 1121.

The extension tab 1121 may contact a surface of the storage device 200 in a state in which the door 112 covers the opening 1111, i.e., in a state in which the door 112 is closed, and here, the position of the fixing hole 1121h may correspond to the position of a hole formed in the storage device 200. In this state, the door 112 and the storage device 200 may be fastened together by using fastening elements such as nuts or screws.

As the extension tabs 1121 are fastened to the storage device 200 while the door 112 is closed, the inverter 100 may be stably fixed to the storage device 200, and as the door 112 is closed and fixed, the circuit board unit 130 inside the main body 111 may be prevented from being exposed to the outside.

A plurality of the extension tabs 1121 may be provided. In an alternative embodiment, the extension tabs 1121 may be arranged on opposite sides of the door 112, respectively.

Referring to FIGS. 4 and 5, the plurality of extension tabs 1121 may be arranged to be spaced apart from each other by a preset interval. A recess 1122 refers to a gap formed by the plurality of extension tabs 1121 being arranged to be spaced apart from each other, and may be an area that does not extend from the door 112.

When the door 112 is closed, the fixing member GM may be positioned in the recess 1122, which is a gap between the extension tabs 1121. In some embodiments, when the door 112 is closed and fastened to the storage device 200, one side of the fixing member GM that is connected to the inverter 100 may be covered by the door 112, and another side that is connected to the storage device 200 may be positioned in the recess 1122.

As the extension tabs 1121 are fastened to the storage device 200 and opposite sides of the fixing member GM connect the storage device 200 to the main body 111, the inverter 100 may form a dual coupling with the storage device 200.

The rod support part 1123 may be further formed on a surface of the door 112 that faces the main body 111. The rod support part 1123, which is formed to protrude in the first direction with reference to the closed state of the door 112, may support the safety rod 113 when the door 112 is open.

In some embodiments, the rod support part 1123 may be formed to protrude in a shape that encloses one end portion of the safety rod 113 that contacts the door 112. A hollow portion, in which the safety rod 113 is seated, may be formed on the surface of the rod support part 1123 that contacts the door 112.

When the door 112 opens at a preset angle with respect to the main body 111, one end portion of the safety rod 113, which was fixed to a surface of the main body 111, may be lifted up and fitted into the hollow portion of the rod support part 1123, and accordingly, the safety rod 113 may stably fix and support the door 112.

The door 112 may be supported by the safety rod 113 through contact, and thus prevented from being closed.

In a case in which the safety rods 113 are arranged on opposite sides of the main body 111, respectively, the rod support parts 1123 may also be arranged on opposite sides of the door 112, respectively. Accordingly, a plurality of safety rods 113 may contact a plurality of rod support parts 1123, and the door 112 may be prevented, by the plurality of safety rods 113, from tilting due to its own weight, and may stably maintain the open state.

The safety rod 113, which has one end rotatably connected to the main body 111 and another end supported by the door 112, may have the shape of an elongated rod. In some embodiments, the safety rod 113 may be capable of sliding movement in a vertical direction through a rod hole, which is formed in a slot shape at one end portion thereof connected to the main body 111.

The safety rod 113 may be arranged between the main body 111 and the door 112, to support the door 112, allowing the door 112 to remain open without being closed.

When the door 112 is open, one end of the safety rod 113 may be rotatably connected to the main body 111, and another end may be supported through contact by the rod support part 1123 of the door 112. Accordingly, the door 112 may stably remain open.

When the safety rods 113 are separated from the rod support parts 1123, the door 112 may come down by gravity to be closed. The other ends of the safety rods 113, which are separated from the rod support parts 1123, may be positioned on a surface of the main body 111, and may be fitted into fixing clips (not shown) arranged on opposite sides of the main body 111 to be fixed in position.

Referring to FIGS. 6 and 7, the heat dissipation case 140, which covers one side of the main case 110 and has a plurality of heat dissipation fins 143, may include a first body 141, a second body 142, and heat dissipation fins 143.

The first body 141 has an internal space and accommodates the circuit board unit 130, and the heat dissipation fins 143 may be formed on a side of the first body 141 that is opposite to the side on which the circuit board unit 130 is arranged. In some embodiments, the circuit board unit 130 may be arranged on an inner surface IS of the first body 141, which forms an internal space, and the heat dissipation fins 143 may be formed on the surface opposite to the inner surface IS to protrude outward.

Accordingly, heat generated from a circuit board arranged in the internal space may be transferred through the first body 141 to the heat dissipation fins 143 and effectively dissipated to the outside.

The second body 142, which is arranged adjacent to the heat dissipation fins 143 and has an internal space, may be formed to protrude from the first body 141 in the first direction. As the second body 142 protrudes outward, a space in which a circuit board may be additionally accommodated may be formed inside the second body 142.

Accordingly, inside the inverter 100 according to an embodiment of the present disclosure, a plurality of circuit boards that constitute the circuit board unit 130 may be stacked to be supported by the main plate MP, the first body 141, and the second body 142.

A plurality of heat dissipation fins 143 may be provided and arranged on a surface of the heat dissipation case 140 to protrude outward.

The heat dissipation fins 143 may extend in a vertical direction, may each have a long and thin shape, and may be arranged on the heat dissipation case 140 to be spaced apart from each other by a preset interval. Due to such an optimized structure of the heat dissipation fins 143, the surface area of the heat dissipation case 140 may be maximized, and the heat dissipation efficiency may be increased.

The heat dissipation fins 143 may include various materials, for example, a metallic material with high thermal conductivity, such as aluminum or copper. However, the present disclosure is not limited thereto, and various modifications to the material are possible within the technical scope where the material has high thermal conductivity and is capable of efficiently dissipating heat from the inside of the heat dissipation case 140.

Referring to FIG. 7, connection protrusions 1401, which each have a surface that faces the storage device 200, and are formed to protrude from a lower portion (in FIG. 6) of the heat dissipation case 140, may be connected to the support members SM, which will be described below.

In some embodiments, the connection protrusions 1401 may be arranged parallel to a surface (the upper surface in FIG. 7) of the storage device 200 on which the inverter 100 is seated. The support member SM may be arranged between the connection protrusion 1401 and the storage device 200, which are arranged parallel to each other. One end of the support member SM may be connected to the storage device 200, and another end of the support member SM may be connected to the connection protrusion 1401.

The heat dissipation case 140 may be connected to the support members SM through the connection protrusions 1401 to be fixed in position on the storage device 200.

The connection protrusions 1401 may be symmetrically arranged on opposite sides of the heat dissipation case 140, respectively, and the support members SM may be provided to be connected to the connection protrusions 1401 so as to support the opposite sides of the heat dissipation case 140, respectively.

In a case in which the connection protrusions 1401 are arranged on opposite sides of the heat dissipation case 140 such that the opposite sides of the heat dissipation case 140 are supported, the load of the heat dissipation case 140 and the circuit board unit 130 accommodated therein may be distributed to the opposite sides, and the risk of deformation or damage due to the load of the heat dissipation case 140 may be reduced.

Furthermore, resistance to external forces and vibration is increased, and thus, balance may be stably maintained.

Referring to FIG. 7, the hood cover 150, which surrounds the heat dissipation case 140 and is connected to the main case 110, may protect the heat dissipation case 140 from external impacts.

In some embodiments, the hood cover 150 may physically block a user or worker from contacting the surface of the heat dissipation case 140, which reaches a high temperature due to heat generated from the internal circuit boards, thereby protecting the user and worker.

The hood cover 150 may include a side cover 151 and a connection cover 152.

The side cover 151 extends along a side surface of the heat dissipation case 140, and a pair of the side covers 151 may be provided on opposite side surfaces of the heat dissipation case 140.

In other words, the side covers 151 may extend in a vertical direction from opposite side surfaces of the heat dissipation case 140, respectively. Lower end portions (lower portions in FIG. 7) of the pair of side covers 151 may each be fastened to the storage device 200.

In this case, one end portion of one side cover 151 may be fastened to a fastening member FM, which is welded to the main case 110, to be connected to the main case 110, and the opposite end portion may be fastened to another fastening member FM, which is welded to the storage device 200, to be connected to the storage device 200.

A handle 1511 may be formed along one side of the side cover. The handle 1511 has a structure in which one surface of the side cover 151 is recessed in the first direction, and may be formed by machining one surface of the side cover 151.

The handle 1511 may be formed in each of the pair of side covers 151. The pair of handles 1511 are formed in a symmetrical structure, such that an operator may easily grip the hood cover 150 when installing and detaching the inverter 100.

The hood cover 150 may include the connection cover 152 that connects the pair of side covers 151 to each other. The connection cover 152 is arranged between the side covers 151 and may extend in the second direction.

The hood cover 150 may have a plurality of cover holes 152h that serve as passages between the interior and the exterior and extend in the first direction.

The plurality of cover holes 152h may allow heat discharged from the heat dissipation case 140 to be effectively dissipated to the outside of the hood cover 150.

In some embodiments, the plurality of cover holes 152h may be arranged on the connection cover 152 and may be spaced apart from each other by a preset interval on the connection cover 152. In some embodiments, the plurality of cover holes 152h may be arranged to be spaced apart from each other in the second direction, which is the lengthwise direction of the connection cover 152.

The cover holes 152h may be passages through which heat discharged from the heat dissipation fins 143 escapes. Because the plurality of heat dissipation fins 143 and the plurality of cover holes 152h are all arranged to be spaced apart from each other in the second direction, heat discharged through the heat dissipation fins 143 may be easily dissipated to the outside through the cover holes 152h.

Furthermore, the cover holes 152h, which serve as passages between the interior and exterior of the hood cover 150, may facilitate air circulation between an inner side and an outer side of the inverter 100 to prevent heat from accumulating in a specific area.

Referring to FIG. 7, the fastening member FM, which has a bent shape and is fastened to the hood cover 150, may connect the hood cover 150 to the storage device 200.

A plurality of fastening members FM may be provided. Some of the plurality of fastening members FM may be welded to a rear surface portion of the main body 111 to fix the hood cover 150 to the main body 111.

In some embodiments, a total of four fastening members FM may be welded to a rear surface portion of the main body 111. The four fastening members FM may form two pairs, and the pairs may be arranged in an upper portion (not shown) and a lower portion (the lower side in FIG. 7) of the main body 111, respectively.

In this case, a bent end and another end of each of the two fastening members FM arranged in the lower portion of the main body 111 may be connected to the hood cover 150 and the storage device 200, respectively. In some embodiments, a surface connecting the bent end to the other end may be welded to a rear surface portion of the main body 111.

In some embodiments, some of the plurality of fastening members FM may each have one end welded to the storage device 200 and another end fastened to opposite lower ends (the lower side in FIG. 7) of the hood cover 150, to fix the hood cover 150 to the storage device 200.

That is, because the main case 110 is connected to the hood cover 150 by the fastening members FM, and the hood cover 150 is connected to the storage device 200, the main case 110 may be indirectly fixed to the storage device 200.

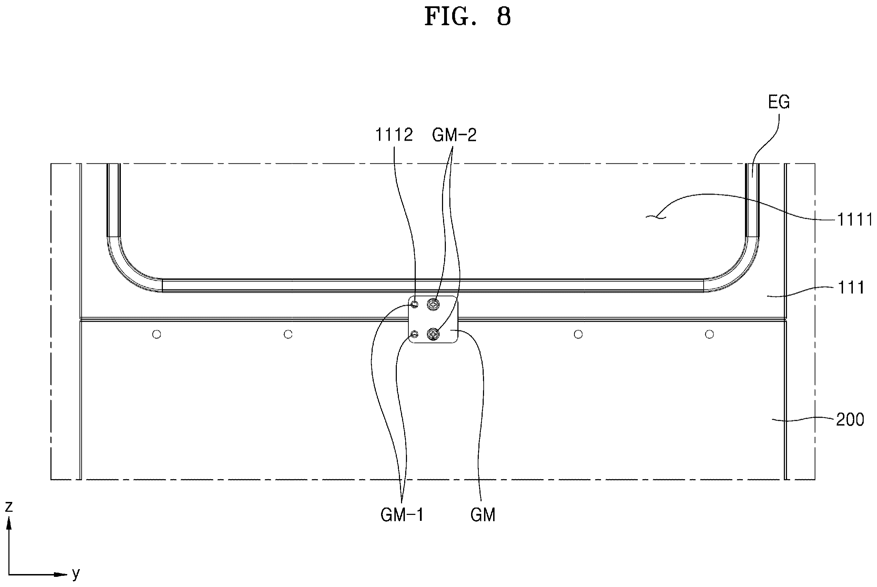

FIG. 8 is an enlarged view of portion A of FIG. 5. Referring to FIG. 8, the fixing member GM has one side connected to the main case 110 and another side connected to the storage device 200, and may have guide holes GM-1 on an inner side thereof, through each of which a protrusion may pass. The fixing member GM may extend in a vertical direction, and a plurality of guide holes GM-1 may be arranged to be spaced apart from each other in the vertical direction.

In some embodiments, the guide protrusion 1112 may be formed to protrude from a surface of the main case 110, and a separate protrusion may be formed to protrude from the storage device 200. In this case, the guide protrusion 1112 of the main case 110 may be fit-coupled to the guide hole GM-1 formed in an area adjacent to the main case 110. Furthermore, the protrusion formed to protrude from a surface of the storage device 200 may be fit-coupled to the guide hole GM-1 formed in an area adjacent to the storage device 200.

That is, the guide holes GM-1 formed in the fixing member GM may be connected to the main case 110 and the storage device 200, respectively, and as a plurality of protrusions are fit-coupled to the guide holes GM-1, the inverter 100 and the storage device 200 may be aligned in a straight line.

In this state, when the fixing member GM is fastened, the main case 110 and the storage device 200 may be vertically connected to each other while being aligned in a line. In other words, the guide protrusion 1112 and the protrusion of the storage device 200 may be aligned on the same straight line.

When the fixing member GM connects the main case 110 to the storage device 200, the guide protrusion 1112 may assist in the alignment of the two devices, and may guide the main case 110 into its correct position on the storage device 200.

The fixing member GM may further include mounting holes GM-2 arranged on one side of the guide holes GM-1. The mounting hole GM-2, like the guide hole GM-1, may be arranged on the fixing member GM in a vertical direction.

The mounting holes GM-2 are passages through which fastening elements, such as screws, may pass, and the fastening elements may pass through the mounting holes GM-2 to fix the fixing member GM to the storage device 200 and the main case 110.

That is, the inverter 100 and the fixing member GM may be fastened to each other through the mounting hole GM-2 formed on one side adjacent to the main case 110, and the storage device 200 and the fixing member GM may be fastened to each other through the mounting hole GM-2 formed on another side adjacent to the storage device 200.

Accordingly, the inverter 100 and the storage device 200 may be aligned in a line and then fixed in position, and the front surface of the inverter 100 may be stably coupled to the storage device 200.

Furthermore, the fixing member GM may maintain the fixation between the main body 111 and a front portion of the storage device 200, even when the door 112 is opened or detached.

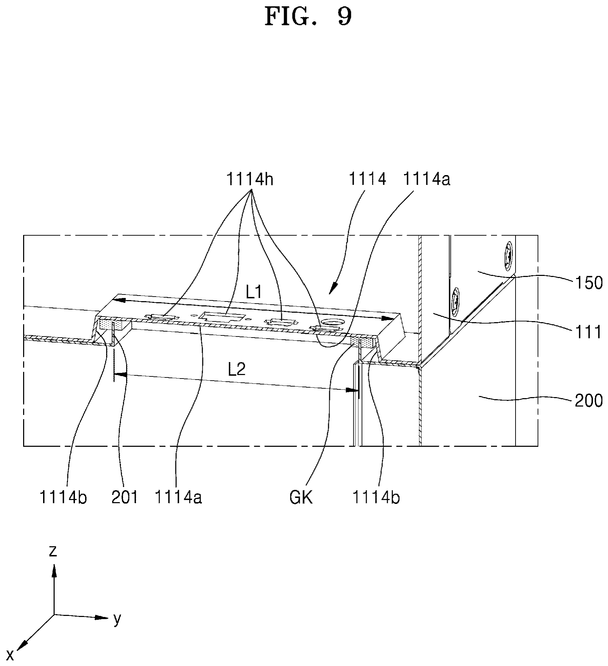

FIG. 9 is a cross-sectional view taken along line V-V' of FIG. 5.

Referring to FIG. 9, the coupling groove 1114 is formed to have a preset depth on a surface of the inverter 100 that faces the storage device 200, and cables of the inverter 100 and the storage device 200 may be coupled or electrically connected to each other on the inner side of the coupling groove 1114.

The coupling groove 1114 may be arranged at an edge of the inverter 100. In some embodiments, the coupling groove 1114 may be arranged at a position distant from a central portion of the inverter 100 where the guide protrusion 1112 is arranged, and may be arranged to be biased toward the left side or the right side (in FIG. 5) of the inverter 100.

When the inverter 100 is installed on the storage device 200, the connection protrusion 201 formed at a position corresponding to the coupling groove 1114 may be positioned inside the coupling groove 1114. Thus, the connection protrusion 201 may also be positioned to be biased toward the left side or the right side of the upper surface of the storage device 200.

Here, the gasket GK may be arranged inside the coupling groove 1114, and when the inverter 100 is mounted on the storage device 200, the connection protrusion 201 may apply a force to the gasket GK in a vertical direction to compress the gasket GK.

The connection protrusion 201 is formed to protrude from a surface of the storage device 200 in the form of a partition wall having a preset height, and may have four surfaces. A hollow portion may be formed inside an area enclosed by the connection protrusion 201.

A cable inside the storage device 200 may exit to the outside through the hollow portion, and in this case, the cable that has exited to the outside may be connected to the coupling groove 1114. In some embodiments, a cable inside the storage device 200 may be connected to a connector inserted into the coupling hole 1114h, or may pass through the coupling hole 1114h to be introduced into the inverter 100.

Furthermore, the respective partition walls forming the four surfaces of the connection protrusion 201 may compress the respective corners of the gasket GK, which are arranged along the inner circumference of the coupling groove 1114. Here, each partition wall may have a narrow width and may have the shape of a protruding blade. Accordingly, the connection protrusion 201 may compress the gasket GK with a larger pressure, and the sealing performance of the energy storage system 20 may be improved.

The coupling groove 1114 may have a first surface 1114a that faces the storage device 200, and second surfaces 1114b that are connected to the first surface 1114a and arranged to be inclined outward.

The first surface 1114a is arranged parallel to the storage device 200 and may be formed parallel to the upper surface of the storage device 200. The second surfaces 1114b may be arranged on opposite sides of the first surface 1114a, respectively. The second surface 1114b may have a preset angle with respect to the first surface 1114a and may be arranged to face outward.

Accordingly, when the inverter 100 is installed on the storage device 200, the connection protrusion 201 may be easily positioned inside the coupling groove 1114 to compress the gasket GK.

The coupling groove 1114 according to an embodiment of the present disclosure may have a width-direction length L1 (hereinafter referred to as "width L1 of the coupling groove 1114"). In detail, the width L1 of the coupling groove 1114 may refer to a length of the first surface 1114a in the second direction. Here, the connection protrusion 201 may also have a width-direction length L2 (hereinafter referred to as "width L2 of the connection protrusion 201").

Referring to FIG. 9, the coupling groove 1114 may have a larger width-direction length than the connection protrusion 201. In other words, the width L1 of the coupling groove 1114 may be greater than the width L2 of the connection protrusion 201. Accordingly, the inner circumference of the coupling groove 1114 may be greater than the outer circumference of the connection protrusion 201.

When the inner circumference of the coupling groove 1114 is greater than the outer circumference of the connection protrusion 201, the connection protrusion 201 may be easily seated inside the coupling groove 1114. Furthermore, a plurality of partition walls forming the connection protrusion 201 may all be covered by the second surfaces 1114b of the coupling groove 1114.

That is, when connecting the inverter 100 to the storage device 200, a side surface of a passage through which a cable passes may be doubly covered by the connection protrusion 201 and the second surfaces 1114b of the coupling groove 1114.

Furthermore, the gasket GK is arranged at a portion where the coupling groove 1114 and the connection protrusion 201 come into contact with each other, and as the connection protrusion 201 compresses the gasket GK, the side surface and the upper and lower surfaces of the cable passage may be completely sealed such that the introduction of outside air, such as dust or moisture, may be blocked.

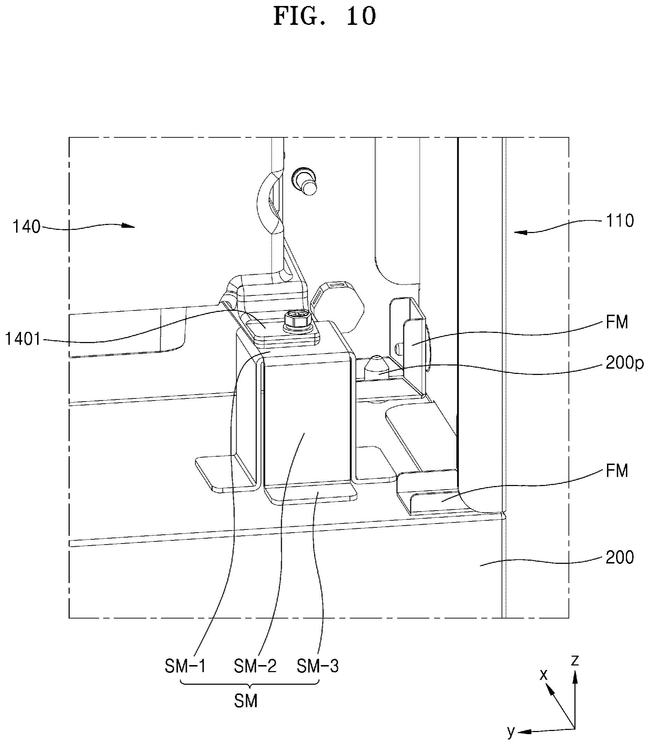

FIG. 10 is an enlarged view of portion B of FIG. 7.

Referring to FIG. 10, the inverter 100 may further include the support members SM arranged between the heat dissipation case 140 and the storage device 200.

In some embodiments, the support member SM has one side connected to the connection protrusion 1401 and another side connected to the upper surface of the storage device 200, and may support the heat dissipation case 140 while connecting the rear surface of the inverter 100 to the storage device 200. In some embodiments, the support members SM may space the heat dissipation case 140 and the storage device 200 apart from each other by a preset interval.

The support member SM may be formed in a pillar shape and may include a contact surface part SM-1, side surface parts SM-2, and support surface parts SM-3. The contact surface part SM-1 may be the upper surface (the upper surface in FIG. 10) of the support member SM, in other words, a surface that comes into contact with the connection protrusion 1401.

When the inverter 100 is installed on the storage device 200, the contact surface part SM-1 may be positioned such that the upper surface of the contact surface part SM-1 comes into contact with the lower surface of the connection protrusion 1401, and then be fixed by a fastening element.

The side surface parts SM-2 extending in a vertical direction may be arranged at edges of the contact surface part SM-1. The side surface parts SM-2 form side surfaces of the support member SM, and may connect the contact surface part SM-1 to the support surface parts SM-3.

In an alternative embodiment, the side surface parts SM-2 may be connected to three edges of the contact surface part SM-1 and extend in a vertical direction.

The support surface parts SM-3 may be arranged at ends of the side surface part SM-2 that are not connected to the contact surface part SM-1. The support surface parts SM-3 are areas connected to the storage device 200, and may each be arranged in a direction toward the outside of the support member SM.

Accordingly, when the heat dissipation case 140 is supported by the support members SM, the weight of the heat dissipation case 140 and the circuit board unit 130 accommodated therein may be distributed and supported on opposite sides, such that the heat dissipation case 140 may be stably positioned on the storage device 200.

Furthermore, the upper surface of the support member SM may undergo a masking treatment to secure grounding continuity between the heat dissipation case 140 and the storage device 200.

The support members SM may space the storage device 200 and the heat dissipation case 140 apart from each other by a preset interval. Here, the gap between the storage device 200 and the heat dissipation case 140 may be the same as the vertical height of the support members SM.

Accordingly, a separation space may be formed between the storage device 200 and the heat dissipation case 140. Through the separation space, outside air may be smoothly supplied to the side of the heat dissipation fins 143, and thus, overheating of the inverter 100 may be prevented.

Furthermore, the separation space serves to prevent the transmission of vibration generated in any one device to the other device, thereby improving the stability of the devices.

A protrusion 200p protruding in a vertical direction may be formed on a surface of the storage device. A plurality of the protrusions 200p may be arranged on the storage device 200 to be spaced apart from each other in the second direction.

Referring to FIG. 6, a hollow portion may be formed on a surface of the fastening member FM that comes into contact with the storage device 200.

Referring again to FIG. 10, the protrusion 200p may pass through the hollow portion of the fastening member FM to fix the position of the main case 110. In some embodiments, the fastening member FM, through which the protrusion 200p passes, has one surface welded to the main case 110, and may guide the inverter 100 into its correct position along the first and second directions when assembling the inverter 100 and the storage device 200.

In other words, during the installation of the inverter 100, the position of a front portion of the inverter 100 may be guided by the guide protrusion 1112 and the fixing member GM, and the position of a rear portion of the inverter 100 may be guided by the protrusions 200p and the fastening members FM.

Accordingly, when assembling the inverter 100 and the storage device 200, the degrees of freedom of the inverter 100 with respect to the first direction and the second direction may be constrained.

That is, the guide structure may guide the position of the inverter 100 such that the connection protrusion 201 is seated inside the coupling groove 1114 at once when placing the inverter 100 onto the storage device, and accordingly, the gasket GK, which is attached to the coupling groove 1114, may be prevented from being damaged by the protruding blade structure of the connection protrusion 201.

Hereinafter, an installation method and the effects of the inverter 100 according to an embodiment of the present disclosure will be described.

The inverter 100 according to an embodiment of the present disclosure is to be electrically connected to the storage device 200, and may be coupled to the connection protrusion 201 of the storage device 200.

The inverter 100 may include the main case 110, the safety cover 120, the circuit board unit 130, the heat dissipation case 140, the hood cover 150, the fixing member GM, the support members SM, and the fastening members FM.

Referring to FIG. 3, the inverter 100 may be installed on a surface of the storage device 200, and may be coupled the storage device 200 in a vertical direction. Here, the front surface of the inverter 100 may be connected to the storage device 200 by the fixing member GM, and the rear surface thereof may be connected to the storage device 200 by the support members SM. In some embodiments, the hood cover 150 surrounding the heat dissipation case 140 may be connected to the main case 110 and the storage device 200 by a plurality of fastening members FM.

Referring to FIG. 5, the fixing member GM is formed to extend in a vertical direction and connects the front surface of the inverter 100 to the storage device 200, and one side of the fixing member GM may be coupled to the inverter 100 while the opposite side may be coupled to the storage device 200.

In some embodiments, the fixing member GM may have a plurality of guide holes GM-1 arranged to be spaced apart from each other in a vertical direction. The guide hole GM-1 arranged on one side of the fixing member GM may be fit-coupled to the guide protrusion 1112 protruding in the first direction from a surface of the inverter 100.

Furthermore, the guide hole GM-1 arranged on another side of the fixing member GM may be fit-coupled to a separate protrusion protruding in the first direction from a surface of the storage device 200.

As the guide holes GM-1 of the fixing member GM are fit-coupled to the inverter 100 and the storage device 200, respectively, the central axes of the inverter 100 and the storage device 200 may coincide with each other, and the two devices may be linearly aligned in a vertical direction.

Here, the fixing member may have the mounting holes GM-2 arranged adjacent to the respective guide holes GM-1. Like the guide holes GM-1, a plurality of mounting holes GM-2 may be arranged to be spaced apart from each other in the lengthwise direction of the fixing member GM, that is, a vertical direction.

Here, as fastening elements, such as screws, are inserted into the mounting holes GM-2, the fixing member GM may be fastened to the inverter 100 and the storage device 200. That is, as the fixing member GM aligns the inverter 100 and the storage device 200 and is fastened to each device, the front surface of the inverter 100 may be connected to the storage device 200.

Referring to FIGS. 7 and 10, the support members SM are formed to extend in a vertical direction and connect the rear surface of the inverter 100 to the storage device 200, and may space the heat dissipation case 140 and the storage device 200 apart from each other by a preset interval.

When the inverter 100 is seated on the upper surface of the storage device 200, a plurality of connection protrusions 1401 protruding from the heat dissipation case 140 may be seated on surfaces of a plurality of support members SM, respectively. In some embodiments, the connection protrusions 1401 may be positioned on the contact surfaces of the support members SM, and in this case, the inverter 100 and the support members SM may be fastened by fastening elements, such as screws and bolts.

A surface of the fastening member FM may be welded to the main case 110, and the bent end of the fastening member FM may be fastened to the hood cover 150. Here, another end of the fastening member FM, which is not fastened to the hood cover 150, may be arranged to face the storage device 200, and a hollow portion may be formed on an inner side thereof.

When the connection protrusion 1401 is positioned on the upper surface of the support member SM, the protrusion 200p may pass through the hollow portion of the fastening member FM. In other words, the protrusions 200p, together with the support members SM, may guide the inverter 100 into its correct position along the first and second directions when the inverter 100 is seated on the storage device 200.

When the inverter 100 and the support members SM are respectively fastened, the front surface and the rear surface of the inverter 100 may each be connected to the storage device 200, and when the installation of the hood cover 150 through the fastening members FM is completed, the position of the inverter 100 with respect to the storage device 200 is fixed.

Finally, after connecting a separate power cable, communication cable, and the like to the inverter 100, the installation of the inverter 100 is completed by closing the door 112 and sequentially fastening the extension tabs 1121, which face a surface of the storage device 200, to the storage device 200.

In the inverter 100 according to an embodiment of the present disclosure, when the fixing member GM, the support members SM, and the fastening members FM fix the position of the inverter 100, the connection protrusion 201 of the storage device 200 may be naturally positioned inside the coupling groove 1114 and compress the gasket GK to form a sealed structure.

Referring to FIGS. 5 and 9, the coupling groove 1114 is formed to be recessed to have a preset depth on a surface of the inverter 100 that faces the storage device 200, and may be arranged on one side of the main body 111. In some embodiments, the coupling groove 1114 may be arranged at a position distant from a central portion of the inverter 100 to which the fixing member GM is fastened.

A surface of the storage device 200 that faces the coupling groove 1114 may have the connection protrusion 201 in the shape of a partition wall formed to protrude in a vertical direction.

By aligning the centers of front portions of the inverter 100 and the storage device 200 through the fixing member GM, and setting the position of a rear portion of the inverter 100 in the first and second directions through the fastening members FM to position the inverter 100 on the storage device 200, the connection protrusion 201 may be naturally inserted into the coupling groove 1114.

Here, the connection protrusion 201 may compress the gasket GK arranged along the inner circumference of the coupling groove 1114, and the inside of the coupling groove 1114 that connects the storage device 200 to the inverter 100 may be completely sealed.

Furthermore, as the connection protrusion 201 is seated inside the coupling groove 1114 at once by the guide structure, the gasket GK, which is attached to the coupling groove 1114, may be prevented from being damaged by the protruding blade structure of the connection protrusion 201.

The present disclosure has an effect in that, when installing the inverter 100, by merely fixing the position of the inverter 100 to the storage device 200, the connection protrusion 201 of the storage device 200 may compress the gasket GK in the coupling groove 1114 to form a sealed structure.

Accordingly, because the coupling groove 1114 and the connection protrusion 201 naturally face each other while a sealed structure is formed by the surrounding connection structure, without needing to directly fasten the coupling groove 1114 to the storage device 200 in a vertical direction, the convenience of installation and dismantling of the inverter 100 is improved.

Furthermore, when replacing the inverter 100, after the fastening of the fixing member GM, the support members SM, the fastening members FM, and the hood cover 150 is released, the inverter 100 may be immediately lifted in a vertical direction and then separated from the storage device 200, thereby facilitating the replacement.

The inverter 100 according to an embodiment of the present disclosure is configured to be separable from the storage device 200, such that in a situation where replacement of the inverter 100 is necessary, only the inverter 100 may be easily separated and then replaced, and thus, costs required for product maintenance may be reduced.

Although an embodiment of the present disclosure has been described above, the spirit of the present disclosure is not limited to the embodiment presented in the present specification, and those skilled in the art who understand the spirit of the present disclosure may easily suggest other embodiments by adding, modifying, or removing components within the same scope of the spirit, but these embodiments will also fall within the scope of the spirit of the present disclosure.

## Claims

1. An inverter comprising:
a main case;
a heat dissipation case that covers one side of the main case and has a plurality of heat dissipation fins;
a circuit board unit arranged in an internal space defined by an assembly of the main case and the heat dissipation case, the circuit board unit having one or more circuit boards configured to mutually convert between direct current power and alternating current power; and
a fixing member that connects the main case to a storage device located outside.

2. The inverter of claim 1, wherein the main case comprises a guide protrusion formed to protrude from a surface thereof.

3. The inverter of claim 1, wherein a surface of the main case has a coupling groove that is recessed inward to have a preset depth, and to which the storage device is connectable.

4. The inverter of claim 3, wherein the coupling groove comprises:
a first surface that faces the storage device; and
a second surface connected to the first surface and arranged to be inclined outward.

5. The inverter of claim 3, further comprising a gasket arranged in a circumferential direction on an inner surface of the coupling groove and contactable to a connection protrusion that is formed to protrude from a surface of the storage device.

6. The inverter of claim 5, wherein the gasket includes an elastically deformable material.

7. The inverter of claim 1, wherein the fixing member comprises a guide hole that is couplable to the main case.

8. The inverter of claim 7, wherein the guide hole is provided as a plurality of guide holes that are couplable to the main case and the storage device, respectively.

9. The inverter of claim 1, further comprising a support member arranged between the heat dissipation case and the storage device to support the heat dissipation case.

10. An energy storage system comprising:
an inverter; and
a storage device,
wherein the inverter comprises:
a main case;
a heat dissipation case that covers one side of the main case and has a plurality of heat dissipation fins;
a circuit board unit arranged in an internal space defined by an assembly of the main case and the heat dissipation case, the circuit board unit having one or more circuit boards configured to mutually convert between direct current power and alternating current power; and
a fixing member that connects the main case to a storage device located outside, and
the inverter and the storage device are electrically connected to each other.

11. The energy storage system of claim 10, wherein the main case comprises a guide protrusion formed to protrude from a surface thereof.

12. The energy storage system of claim 10, wherein a surface of the main case has a coupling groove that is recessed inward to have a preset depth, and to which the storage device is connectable.

13. The energy storage system of claim 12, further comprising a gasket arranged in a circumferential direction on an inner surface of the coupling groove and contactable to a connection protrusion that is formed to protrude from a surface of the storage device.

14. The energy storage system of claim 10, wherein the fixing member comprises a guide hole that is couplable to the main case.

15. The energy storage system of claim 10, further comprising a support member arranged between the heat dissipation case and the storage device to support the heat dissipation case.
